(19)

**Europäisches Patentamt**

**European Patent Office**

**Office européen des brevets**

(11) **EP 2 541 613 A1**

(12) **EUROPEAN PATENT APPLICATION**
published in accordance with Art. 153(4) EPC

(43) Date of publication:
**02.01.2013 Bulletin 2013/01**

(51) Int Cl.:
***H01L 31/04*** (2006.01)

(21) Application number: **11747066.6**

(22) Date of filing: **25.02.2011**

(86) International application number:
**PCT/JP2011/001101**

(87) International publication number:
**WO 2011/105102 (01.09.2011 Gazette 2011/35)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **25.02.2010 JP 2010039816**

(71) Applicant: **National Institute of Advanced Industrial Science and Technology Tokyo 100-8921 (JP)**

(72) Inventors:
• **IWATA, Yasushi Tsukuba-shi Ibaraki 305-8568 (JP)**
• **TOMITA, Kanako Tsukuba-shi Ibaraki 305-8568 (JP)**

(74) Representative: **Henseler, Daniela Sparing Röhl Henseler Patentanwälte Rethelstrasse 123 40237 Düsseldorf (DE)**

(54) **SOLAR BATTERY**

(57) Disclosed is a solar battery using a silicon semiconductor, having a high quantum-conversion efficiency, requiring few number of production steps during manufacturing, and capable of being recycled in view of environmental load and material recycling. Specifically, the solar battery has a basic structure of P-SN-N junction in which refined silicon clusters are inserted in P-N junction, and includes a quantum dot layer having a multiple energy level structure whose energy level is between an energy level of a valence band and an energy level of a conduction band. The quantum dot layer includes a periodic arrangement of silicon quantum dots formed of silicon clusters of 2.5 nm or less in average particle diameter and the distance between the quantum dots is 1 nm or less.

*F I G. 3*

EP 2 541 613 A1

**Description**

BACKGROUND OF THE INVENTION

Technical Field:

The present invention relates to a solar battery using a silicon cluster.

Background Art:

Recently, it has been longing for the advent of a practical solar battery excellent in conversion efficiency. The conversion efficiency of a photo-voltaic p-n junction is given as a function of the band gap Vg of the p-n junction. One can determine the limit of the conversion efficiency by consideration of the condition where radiation from the excited excitons in the p-n junction is balanced with an amount of absorption, which is necessary for excitation of the excitons, of the sun light with a distribution of black-body radiation from a surface at a temperature of 6000K. The limiting value of the conversion efficiency reaches the maximum value of 31% at Vg = 1.3eV near a band gap of silicon crystals. The maximum value is considered to be theoretical limit of the conversion efficiency of the silicon solar battery.

The conversion efficiency of the silicon photo-voltaic P-N junction is practically half or less of the theoretical value of the limited conversion efficiency because the lifetime of carriers in the photo-voltaic p-n junction is shorten at the interface connected with electrodes, and recombination of carriers occurs in the depletion layer of the photo-voltaic P-N junction. The conversion efficiency of the silicon photo-voltaic P-N junction has been improved up to 24% at most because the lifetime of carriers is elongated by passivation of the interface connected with electrodes. Recombination of carriers in the interface is suppressed by inserting a layer of amorphous silicon (a-Si:H) between the p-n junction. The intermediate layer composing a hetero junction of a-Si:H which possesses a high band gap plays a role of a buffer area. Thereby, high open-circuit voltage is obtained and then the conversion efficiency becomes a higher value exceeding 20%.

Photo-voltaic P-N junctions of crystalline silicon have monopolized marketing the current solar battery. The cost of raw materials becomes a greater part in the total of the expenses of manufacturing the solar battery, as mass-production and reducing the expense of the solar battery is in progress. It is reported that the cost of raw materials exceeds 70% in some cases. A low price solar battery of silicon thin films, in which raw materials of crystalline silicon of great price are made no use, has been developed. The solar battery of silicon thin films is manufactured by deposition of silicon thin film on a wide glass substrate with an area size of $1m^2$. Thereby, a flexible and large area solar battery is realized, which achieves rapid access to market in recent years. Introduction of a new conceptual solar cell which can realize to make its conversion efficiency so high enough to exceed by far the theoretically-limited value of 31% is indispensable to development in the photovoltaic technologies to aim for progress in the autonomous energy supply systems, which lighten the load of the electric power supply systems and spread their utility widely.

Conventionally, for a silicon quantum dot solar battery, silicon nanocrystal (nc-Si) which is dotted in a silicon oxide layer ($SiO_2$) has been utilized. The nc-Si / $SiO_2$ quantum dot layer is formed by annealing a material which is initially formed by alternately stacking amorphous silicon (a-Si) and silicon oxide ($SiO_2$) for about one hour at 1050 °C to 1100 °C, to precipitate silicon in the a-Si layer and form nc-Si. In some cases, silicon nitride ($Si_3N_4$) or silicon carbide (SiC) may be used, instead of the stacked $SiO_2$ layers (see Non-Patent Document 1). In the formed nc-Si/$SiO_2$ quantum dot layer, nc-Si is distributed with broad particle diameter dispersion ranging from a fine particle of 2nm in diameter to a huge particle of 5nm or more in diameter. Also, particle spacing of nc-Si is not uniform and a particle separated by spacing 5nm or more can often be found. The same thing mostly holds true for nc-Si/$Si_3N_4$ and nc-Si/SiC quantum dot layers. The density of the silicon quantum dots is $10^{10}$ order per unit area ($1cm^2$) and is up to $1 \times 10^{11}$ at most in each layer. The present inventors continue search and development of silicon nanoclusters (see Patent Documents 1 and 2, and Non-Patent Documents 2 and 3).

Prior Art Document

Patent Documents

Patent Document 1: JP.2001-158956 A

Patent Document 2: JP 2007-162059 A

Non-Patent Documents

Non-Patent Document 1: G. Conibeer et al "Silicon quantum dot nanostructures for tandem photovoltaic cells", Thin Solid Films, 516(2008) pp 6748-6756.
Non-Patent Document 2: Yasusi Iwata et al, "Array order formation of silicon nanoblocks and practical application of thin film deposition system", Laser Processing Academic Journal, 10 (2003) pp 57-60.
Non-Patent Document 3: Yasusi Iwata et al, "Narrow size-distributed silicon cluster beam generated using a spatiotemporal confined cluster source", Chem. Phys. Lett., 358(2002) 36-42.

Summary of the Invention

Problem to be solved

The conventional nc-Si/$SiO_2$ quantum dot layer does not meet the conditions necessary to realize high conversion efficiency of the quantum dot solar battery. Note that the quantum dot is a spatially-limited atomic cluster in which the motion of all of the valence electrons is quantized by spatial limitation. When the atomic clusters of semiconductor have a granular shape possessing as same size as de Broglie wavelength (several nm to 20 nm) of the valence electrons, the spatially-confined valence electrons in the atomic cluster form a wider-band gap structure. It has been desired to find conditions necessary for the quantum dot layer to function as a solar battery.

The current silicon quantum dot solar battery has been reported to have a value of at most 10% of the efficiency which is lower than that of a polycrystalline silicon solar battery. Further, the current silicon quantum dot solar battery has disadvantage in its production method. The standard production process of the current silicon quantum dot solar battery has as many number of steps as the number of the quantum dot layers for stacking a-Si layers and $SiO_2$ layers alternately in each thickness of several nm and then annealing in each step for a time of one hour at a temperature higher than 1000°C. The other method of alternately stacking a-Si and $SiO_2$ /$Si_3N_4$ /SiC still has a technical problem in reuse of materials.

The cost of raw materials becomes a greater part in the total of the expenses of manufacturing the solar battery In the present invention, it is necessary to clarify a band structure required as a solar battery (technical problem 1). Further, in the silicon cluster solar battery production, materials that place less environmental load and are recyclable have to be used, assuming beforehand mass use of the solar batteries from a practical point of view (technical problem 2). Furthermore, it is essential to design a device structure which can be produced by fewer number of production steps for improving productivity (technical problem 3). Moreover, considering about the present technology that the cost of raw materials becomes a greater part in the total of the expenses of manufacturing the solar battery of the conventional polycrystalline silicon, the absorption coefficient of useful materials for the solar battery with respect to sunlight spectrum is important to solve technological problem to produce thinner structures of the silicon cluster solar battery. It is essential that the cluster layer exhibits a high absorption coefficient with respect to the sunlight spectrum (technical problem 4). The efficiency of the silicon cluster solar battery is determined by the lifetime of carriers and interface control (technical problem 5).
The present invention is made in light of the aforementioned conventional drawbacks and the technological problems and an objective of the invention is to provide a silicon cluster solar battery which affords a high electromotive force, high absorption efficiency, high quantum conversion efficiency, and is excellence in carrier conductivity.

Solution to the problem

The present invention has the following features to accomplish the above-identified objective.
The present invention comprises quantum dot layers possessing a multiple energy level structure consisting of energy levels of a valence band, energy levels of a conductance band, and intermediate energy level formed between both the bands. In the present invention, the quantum dot layers are composed of silicon clusters of 2.5 nm or less in average diameter forming up periodically in order at an inter-distance of 1 nm or less. The average particle diameter can be found by measuring particle diameters of the silicon clusters in an observation area of the silicon clusters, and by taking a statistics average thereof. When the silicon cluster forms up a periodic ordering structure, a statistics average is taken for every constant period continuing area (coherent length). By setting the average particle diameter to 2.5 nm or less, the silicon cluster may have a cage structure excellent in carrier conductivity in a surface layer and achieve a an excellent quantum-conversion efficiency showing an absorption coefficient 2 digits higher compared with the polycrystalline silicon. It is also possible to implement thinning of the silicon cluster layer composed of the silicon cluster. Thus, these superior merits overcome the technical problems to be solved by the present invention. Further, when the distance between quantum dots is set to 1 nm or less, an electron wavenumber spreads over inter-cluster, which allows a generated carrier to directly migrate between the inter-clusters, thereby achieving current density higher than tunneling current. In the present invention, it is preferable that the quantum dot layers are composed of the silicon cluster layers stacked up to 300 layers to have a thickness of 1μm or less. Moreover, when the silicon cluster layers are stacked by 100 to 300 layers, the stacked silicon cluster layers exhibit a sufficient light absorption function to sunlight spectrum. Therefore, it is preferable to perform the above method, as an effect of the present invention becomes conspicuous.

Besides, in the solar battery of the present invention a graphene layer may be laid on an interface of the quantum dot layers.

The production method of the present invention is a method to produce a solar battery to form a quantum dot layers possessing a multiple energy level structure having an intermediate energy level between an energy level of a valence band and an energy level of a conductance band, by forming up a silicon quantum dot layers composed of silicon cluster layers periodically in order.

Advantageous Effects of the Invention

According to an embodiment of the present invention, it is possible to reduce environmental load and to use large amount of recyclable materials because the present invention provides a P-$Si_N$-N junction solar battery in which refined silicon cluster is inserted between silicon P-N junction (hereinafter referred to as a "μ-$Si_N$ cluster"). Further, according to an embodiment of the present invention, the μ-$Si_N$ cluster layers inserted between the P-N junction having a high electromotive force have effects of providing a quantum conversion efficiency two digits higher compared with the conventional polycrystalline silicon, and high carrier conductivity resulting from the cage structure appearing on a surface layer of the μ-$Si_N$ clusters.

Furthermore, the invention attains high conversion efficiency over 31% of the limiting value of the conversion efficiency of the silicon solar battery based on passivation control in a bonded interface in the P-$Si_N$-N junction utilizing the graphene. Moreover, according to an embodiment of the present invention, it is possible to expect high conversion efficiency over the conventional conversion efficiency despite the device structure which can be produced by fewer number of production steps, and to improve productivity, and also possible to meet energy demands in future.

Besides, according to an embodiment of the present invention, since the high quantum conversion efficiency attained by the μ-$Si_N$ cluster layer makes effective quantum conversion in a thin layer in which a thickness of the μ-$Si_N$ cluster layer is less than 1 μm, the present invention can suppress to a sufficient degree the material cost of the silicon materials.

Brief Description of the Drawings

FIG. 1 is a view explaining Abrupt P-N junction;
FIG. 2 is a view explaining P-$Si_N$-N junction using a μ-$SI_N$ cluster of the present invention;
FIG. 3 is a view showing a band structure in P-$Si_N$-N junction of the present invention;
FIG. 4 is a view showing a device structure of a silicon cluster solar battery according to a first embodiment of the present invention;
FIG. 5 is a view showing a silicon cluster beam depositing system used for manufacture of the present invention;
FIG. 6 is a view showing an absorption coefficient of a silicon cluster thin film (reduced value based on tauc's plot) of the present invention;
FIG. 7 is a view showing a device structure of a silicon cluster solar battery according to a second embodiment of the present invention; and
FIG. 8 is a view showing an energy dispersion relation of graphene used in the second embodiment of the present invention.

Description of Embodiments

Hereinafter, embodiments in which a solar battery of the present invention is embodied will be explained in detail based on principles and examples.

A high efficiency principle of a quantum dot solar battery of the present invention will be explained below.

In the silicon quantum dot solar battery comprising a quantum dot layers formed by forming up silicon quantum dots made of silicon clusters periodically in order are jointed between a P layer and a N layer of P-N silicon junction, a multiple energy level structure consisting of energy levels of a valence band, energy levels of a conduction band, and intermediate energy levels formed both the bands is formed in quantum dot layers. In the quantum dot layer, according to the periodic ordering of atoms which constitute quantum dot energy levels of valence band and energy levels of conduction band form energy level structure arranged at an interval of an energy gap of a forbidden gap. In addition, a discrete energy level is formed in the forbidden gap due to the periodic arrangement of the quantum dots, having a long period, compared to periodic arrangement of atoms. This newly formed discrete energy level is defined by equations (1) and (2), and is called as an intermediate energy level as it has an intermediate energy levels between energy levels of a valence band and energy levels of a conduction band, which forms a multiple energy level structure together with energy levels of a valence band and energy levels of conduction band. The silicon quantum dot layer in which the silicon cluster is three-dimensionally periodically formed up in order is characterized by its arrangement period dp (p = x, y, z) and by a quantum dot size ($a_x \times a_y \times a_z$). It defines the intermediate energy level Jm. Simply defining periodic potential formed by the quantum dot by rectangular periodic potential (Kronig-penny potential) having height $V_0$ of a barrier, width bp (p = x, y, z), and distance $a_p$ ($d_p = a_p + b_p$), a dispersion relation E (k, $a_p$, $b_p$) of energy of an electron is expressed by the following equation with m* as effective mass of electron, and with k as a wave number.

$$cos(\alpha a_p)cosh(\beta b_p)\frac{\alpha^2 - \beta^2}{2\alpha\beta}sin(\alpha a_p)sinh(\beta b_p) = cos(k d_p) \tag{1}$$

$$\alpha = \sqrt{\frac{2m^* E}{\hbar^2}}, \qquad \beta = \sqrt{\frac{2m^*(V_0 - E)}{\hbar^2}} \tag{2}$$

$\alpha$ and $\beta$ represent respectively momentum of an electron in each case where a neighboring quantum dot interval is defined by barrier free (V = 0) and defined by potential of constant height $V_0$. Because the right side of the equation (1) varies only from -1 to +1, only an area E in which the left side of the equation (1) has a value from -1 to +1 is allowed for an energy level of electrons. The allowed energy level of electrons is discrete and intermediate energy level is defined as an order of $J_1, J_2, \cdots, J_n$ from a low level. According to the equations (1) and (2), it is necessary to arrange the quantum dots in periodic long distance order for stable intermediate energy level formation, so that a size of the quantum dot defining the periodic potential of the silicon quantum dot layer is evenly distributed with the same size, the size of the quantum dot is defined to plural groups of every specific size, or a coherent area of the periodically arranged quantum dots extends over a wide area of the quantum dot layers.

The value of 31% that is considered to be a theoretical limiting value of the conversion efficiency of the silicon solar battery is calculated, assuming that radiation from sunlight is thermally balanced with radiation emitted by deexcitation of exciton of the solar battery, on the basis of the energy level structure only composed of the energy level of the valence band and the energy level of the conduction band. In the silicon quantum dot solar battery, where the multiple energy level structure, including the intermediate energy level of the quantum dot layer forms an energy level structure optimum to absorb sunlight having radiation distribution of 6000k, a theoretical limiting value of its conversion efficiency greatly exceeds the conventional theoretical limiting value. The theoretical limiting value of the conversion efficiency of the silicon quantum dot solar battery increases with a number n of the intermediate energy level. As compared with the theoretical limiting value of 31% of the conversion efficiency in the condition of n = 1, a theoretical limiting value of the conversion efficiency in the condition of n = 2 is 43%, a theoretical limiting value of the conversion efficiency in the condition of n = 3 is 49%, and a theoretical limiting value of the conversion efficiency in the condition of n = $\infty$ is 70%. When an optimum reflective condition is taken on a surface of the solar battery, a theoretical limiting value of the conversion efficiency reaches up to 86.8% at most. Thereby, a value close to a limiting value of 95% of the conversion efficiency of Carnot engine can be obtained. In order for a silicon quantum dot solar battery, which greatly exceeds the theoretical limiting value of the conversion efficiency, and exhibits a theoretical limiting value having a high conversion efficiency to practically function, the silicon quantum dot solar battery has to meet further three conditions below.

Refined silicon cluster ($\mu$-Si$_N$) has a different crystal structure of atom arrangement between a surface and inside of the cluster. Whereas inside of the $\mu$-Si$_N$ cluster forms a diamond structure identical with that of the silicon crystal, a cage structure peculiar to the $\mu$-Si$_N$ cluster is localized in a surface layer. The cage structure includes a n electron which forms $sp^2$ hybrid orbital and exhibits an electronic structure state excellent in conductivity similarly as graphite. In silicon single crystal forming $sp^3$ hybrid orbital, an unpaired electron appears on a crystal surface. Because the unpaired electron captures a carrier, a carrier lifetime extremely shortens on the surface of silicon single crystal. On the other hand, since the carrier conductivity is excellent on a surface of the silicon cluster in the absence of the unpaired electron, a carrier lifetime longer by several digits can be expected compared with the carrier lifetime on the surface of the silicon single crystal. According to a reported case on chemical reactivity of the $\mu$-Si$_N$ cluster, the $\mu$-Si$_N$ cluster has a reaction coefficient smaller by three digits than that of the surface of the silicon single crystal, and is inert to chemical reaction similarly as the graphite surface. This supports a long carrier lifetime thereof.

Next, comparing the cage structure contained in the $\mu$-Si$_N$ cluster with the diamond structure from the perspective of symmetry and periodicity of the structure proves that the diamond structure shows a structure where a Si atom is periodically arranged, with a constant value of the distance between Si atoms adjacent in the cluster, throughout the diamond structure. In contrast, no periodicity can be found in an atomic position of the cage structure inside of the cluster. To form a crystal band structure inside of the $\mu$-Si$_N$ cluster which absorbs a visible light region of sunlight having radiation distribution of 6000k same as a silicon bulk crystal, the $\mu$-Si$_N$ cluster must have the diamond structure. The ratio of two kinds of crystal structures of the $\mu$-Si$_N$ cluster contained in the cluster varies, depending on the size of the cluster. The cage structure is dominant in the $\mu$-Si$_N$ cluster, ranging from an ultra-fine $\mu$-Si$_N$ cluster composed of several Si atoms to a $\mu$-Si$_N$ cluster composed of about 300 Si atoms of up to 2.2 nm in particle diameter. In a case where a Si atomic number is e.g., 420 and a particle diameter is 2.5 nm, the cage structure is locally contained in the cluster surface. On the other hand, the diamond structure appears in the $\mu$-Si$_N$ cluster where the number of Si atom is 190 or more and a particle diameter is 2 nm or more. In an example of actual survey, there is a report that the $\mu$-Si$_N$ cluster has a spherical structure containing the diamond structure in which the number of Si atom is about 40 or more and a particle diameter is 1 nm or more. Namely, in a relatively small $\mu$-Si$_N$ cluster, the cage structure is dominant, the structure transits therefrom to the diamond structure with an increase in size. The size at which a structural transition occurs is considered to be within the range of 1 nm to 3 nm in particle diameter. From the foregoing, it is concluded that necessary conditions of the size of the cluster in which the $\mu$-Si$_N$ cluster includes the diamond structure inside thereof, and which forms the cage structure in the surface layer, in order for the silicon quantum dot layer to function as a practical solar battery, is within the range of at least 1 nm to 3 nm or so in particle diameter, and is within the range of 2 nm to 2.5 nm in ideal average particle diameter (condition 1).

To expect high carrier conduction in the quantum dot layer, as a condition necessary for the silicon quantum dot layer to function as a solar battery, it is desirable that a quantum dot distance be as close as possible to a value below 1 nm at which an electron is able to migrate, provided that the quantum dot distance should not be close to a value, 2.5 Å or less of distance between Si atoms in the sp$^2$ hybrid orbital in the cage structure in the surface layer of the $\mu$-Si$_N$ cluster (condition 2). The sp$^2$ hybrid orbital in the cage structure formed in the surface layer of the $\mu$-Si$_N$ cluster spreads its wave function in a radial direction of the cluster, too. In a state where a distance between the $\mu$-Si$_N$ clusters adjacent to one another in the silicon quantum dot layer is close to a value of 1 nm or less, wave functions slightly overlap with one other and spreading of a wave number of electrons over the inter-cluster can be expected. In the periodically arranged $\mu$-Si$_N$ cluster layer, it becomes possible to have the description in the same way as an atomic model in crystals by a picture in which a cluster inner core is regarded as a point charge having a plus effective charge. The wave number of $\mu$-Si$_N$ cluster surface electrons spread along a point charge period having a plus effective charge, and formation of a new band structure in the $\mu$-Si$_N$ cluster layer can be expected. A carrier generated in the $\mu$-Si$_N$ cluster layer migrates in the layer along the band structure. In the present invention, it becomes possible to generate the $\mu$-Si$_N$ cluster in which an average particle diameter is controlled to be 2.5 nm or less by introduction of the silicon cluster technology, and to form a band by overlapping the wave function of the cluster in which a distance between $\mu$-Si$_N$ clusters is close value of 1 nm or less. As a principle of how an electron migrates between the quantum dots, it is first time to introduce the band formation by overlapping the wave function for a quantum dot solar battery.

Further, in order to mitigate carrier capture in an interface of the quantum dot layers, interface control of the quantum dot layers is necessary (condition 3). The present invention attempts prolongation of a carrier lifetime in interface of the quantum dot layers by introducing the graphene technology represented by graphene to the interface control of the solar battery for the first time.

In the silicon cluster thin film disclosed in the Non-Patent Document 2 which lacks suggestion of application to the solar battery, the $\mu$-Si$_N$ cluster of 2.3 nm in average particle diameter is formed evenly with size dispersion of 5% or less. In the formed silicon cluster thin film, the silicon cluster forms a periodic structure over an area in which arrangement period dp is 3.1 nm, and a coherent length is 100 nm or more. It shows a possibility of generation of an intermediate energy level between the energy level of the valence band and the energy level of the conduction band, following equations (1) and (2), if the silicon cluster thin film is utilized in the silicon quantum dot layer. Furthermore, it is observed that the $\mu$-Si$_N$ cluster in the silicon cluster thin film forms an order and arragemnt s at intervals of 1 nm. This is $1 \times 10^{13}$/cm$^2$ in the arrangement density of the silicon cluster. Comparing it with the arrangement array density of the quantum dot reported to date turns out that the arrangement array density is $1 \times 10^{11}$/cm$^2$ at most even in the most high density quantum dot, and that the silicon cluster thin film shows density two digits higher than it. This meets the condition (1) defining control of the particle diameter of the silicon quantum dot necessary for the silicon quantum dot layer to function as a practical solar battery, and the condition (2) defining the distance between the quantum dots.

In the conventionally reported quantum dot solar battery described in Non-Patent Document 2, in which the silicon quantum dot and the SiO$_2$ layer are alternately stacked, a generated carrier migrates as tunneling current through the SiO$_2$ layer that is an insulating layer. Contrarily, in the silicon quantum dot layer where the $\mu$-Si$_N$ cluster of the present invention is stacked at high density, it is introduced, as a new principle, that the generated carrier directly migrates

between the $\mu$-Si$_N$ clusters close to one another within 1 nm or less due to spreading of the wave number of surface layer electrons. When potential gradient occurs in the $\mu$-Si$_N$ cluster layer, this tendency grows and excellent carrier conductivity promoting efficiency of the solar battery is expected in a solar battery utilizing the silicon cluster thin film.

For high efficiency of the P-Si$_N$-N junction solar battery utilizing the $\mu$-Si$_N$ cluster, at first, a design of the band structure is conducted with the aim of effectively collecting carriers generated in the $\mu$-Si$_N$ cluster layer.

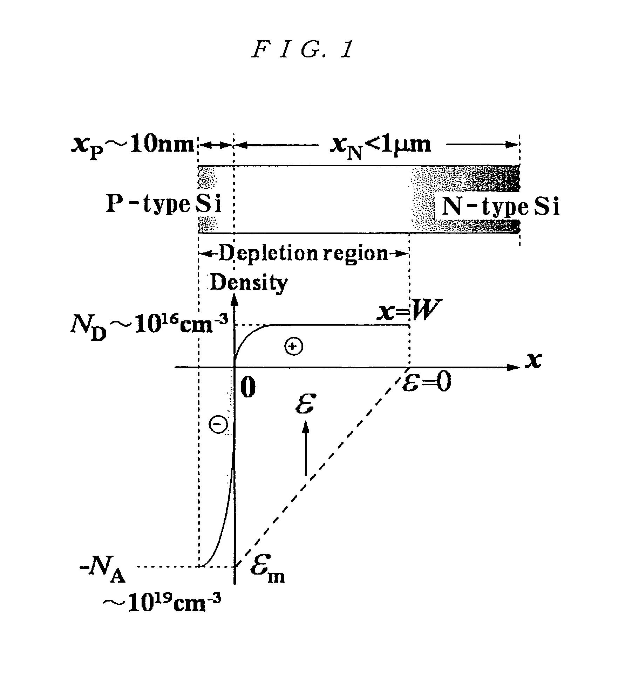

In order to increase mobility of the generated carriers, P-N junction (abrupt PN-junction) is desirable in which a high electromotive force (built-in potential) is generated between the P-N junction where the $\mu$-Si$_N$ cluster layer is inserted and a steep electric field gradient is generated by the electromotive force in the $\mu$-Si$_N$ cluster layer. FIG. 1 is a view explaining the abrupt P-N junction. In an upper section of FIG. 1, a structure of the P-N junction and the thickness of each layer are shown. Corresponding to the structure, the density of the carriers is shown in a lower section of FIG. 1.

In a depletion layer formed in an interface of the abrupt PN junction, a negative charge of P layer acceptor and a positive charge of N layer donor are balanced to form a space charge layer and an electric field gradient is generated in the depletion layer. It is desirable that the thickness of the space charge layer is set to the same level as, or thicker than the thickness of the $\mu$-Si$_N$ cluster layer to be introduced. Under such setting, the $\mu$-Si$_N$ cluster layer always is in the space charge layer. The carriers generated therein always drift being sensitive to the electric field gradient at the same time they are generated, and are effectively collected.

In the P-Si$_N$-N junction, it is important how to set the built-in potential on the P-N junction and the thickness of the space charge layer appeared in the depletion layer. They are defined by acceptor density $N_A$ and thickness $X_A$ of the P layer, and donor density $N_D$ and thickness $X_D$ of the N layer. In the following, the built-in potential Vp, the thickness W of the space charge layer, and the electric filed gradient in the space charge layer will be explained and the band structure necessary for the P-Si$_N$-N junction (technical problem 1) will be clarified.

In the depletion layer of the abrupt PN junction which is in a thermal equilibrium state, a negative electric charge of the acceptor to be injected at high density NA into the P layer having a very thin thickness of $X_p$ = 10nm or less and a positive electric charge of the donor existing in density $N_D$ in the thickness $x_N$ of the depletion layer of the N layer are balanced to form the space charge layer. Here, an equation (3) is established.

$$N_A x_P = N_D x_N .$$ 
$$(3)$$

A high electric field $\varepsilon(x)$ is generated by steep charge density of the P layer in the space charge layer having a thickness W (= $x_P + x_N$). With height of the electric field gradient, the built-in potential $V_b$ which is the difference of evaluation between conductor band edges of the P layer, $E_{CP}$ and that of the N layer, $E_{CN}$ can be highly set. Practically, the built-in potential at room temperature (T = 300k) on condition that the acceptor injection density $N_A$ is $1 \times 10^{19}$cm$^{-3}$ in the P layer, and the donor injection density $N_D$ is $1 \times 10^{16}$cm$^{-3}$ in the N layer are given in the following equations (4), (5),and (6), in which supposing excitation carrier density of intrinsic silicon at room temperature is $n_i$, an elementary charge of the carrier is q, dielectric constant is e, and Boltzmann constant is $k_B$, with the thickness of the space charge layer W and the maximum electric field $\varepsilon_m$.

$$V_b = \frac{k_B T}{q} ln\left(\frac{N_A N_D}{n_i^2}\right) = 0.0259(V) \times ln\left(\frac{1 \times 10^{19} \times 10^{16}}{\left(9.65 \times 10^9\right)^2}\right) = 0.896(V).$$
$$(4)$$

$$W = \sqrt{\frac{2eV_b}{qN_D}} = \sqrt{\frac{2 \times 11.9 \times 8.85 \times 10^{-14}\,(F/cm) \times 0.896(V)}{1.602 \times 10^{-19}\,(C) \times 1 \times 10^{16}\,(cm^{-3})}} = 3.43 \times 10^{-5}\,(cm).$$
$$(5)$$

$$\varepsilon_m = \frac{qN_DW}{e} = \frac{1.602 \times 10^{-19}(C) \times 1 \times 10^{16}(cm^{-3}) \times 3.43 \times 10^{-5}(cm)}{11.9 \times 8.85 \times 10^{-14}(F/cm)} = 5.21 \times 10^4 (V/cm). \quad (6)$$

According to an equation (5), when the donor density of the N layer, $N_D$ has a value ranging from $1 \times 10^{16} cm^{-3}$ to $1 \times 10^{15} cm^{-3}$, the thickness of the space charge layer of the P-N junction, W changes from 343 nm to 1085 nm. Comparing the thickness of the space charge layer with the thickness $X_s$ of the $\mu$-Si$_N$ cluster layer, it is proved that the maximum number of stacks of the $\mu$-Si$_N$ cluster layers satisfying a condition of $x_s \leqq W$, is from 110 layers to 360 layers, when an inter-cluster distance is 3 nm. As the donor density of the N layer decreases, the built-in potential $V_b$ between the P-N junction also decreases following the equation (4), but their difference is small. When a difference of Nb is between $1 \times 10^{15} cm^{-3}$ and $1 \times 10^{16} cm^{-3}$, a decrease in $V_b$ is limited to 6.7%. Rather, considering balance of the space charge, it is desirable that the P layer should be be thinner and to have high carrier density according to the equation (3).

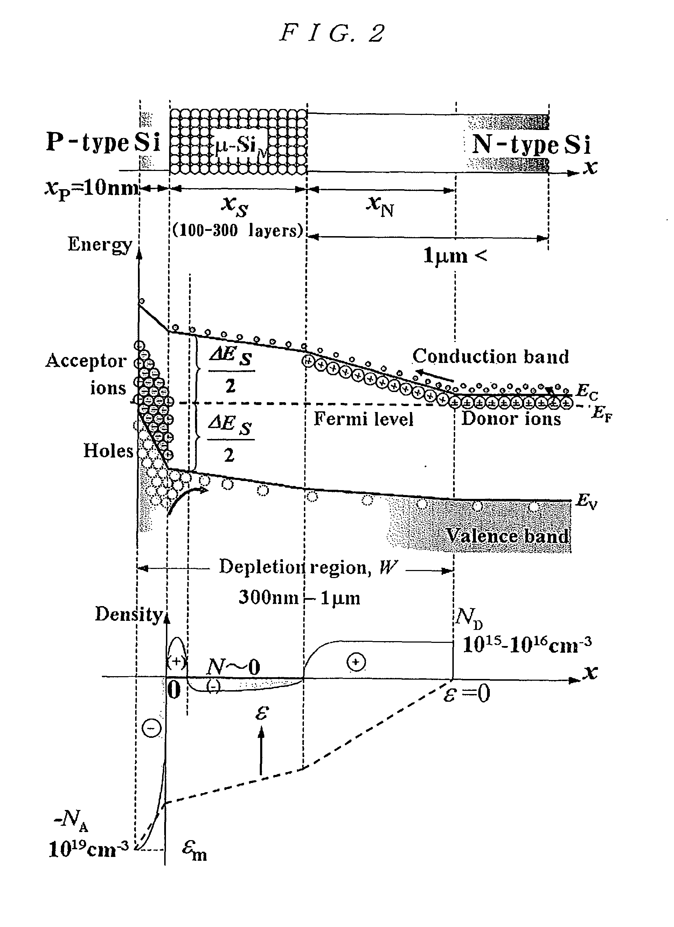

Herein, P-Si$_N$-N junction utilizing the $\mu$-Si$_N$ cluster layer formed from intrinsic semiconductor silicon materials will be explained. FIG. 2 is a view explaining the P-Si$_N$-N junction utilizing the $\mu$-Si$_N$ cluster layer. A structure of the P-Si$_N$-N junction and thickness of each layer is shown in an upper section of FIG. 2. Corresponding to said structure, an energy structure is shown in an intermediate section of FIG. 2, and carrier density is shown in a lower section of FIG. 2. Corresponding to setting the acceptor density of the P layer, $N_A$ to $1 \times 10^{19} cm^{-3}$, and the donor density on the N layer, $N_D$ to $1 \times 10^{15} cm^{-3}$ to $1 \times 10^{16} cm^{-3}$, the $\mu$-Si$_N$ cluster layer is stacked by 100 to 300 layers. In the $\mu$-Si$_N$ cluster layer, carrier electrons of $n_i = 1 \times 10^{10}$ cm$^{-3}$ in a thermal equilibrium state at room temperature are excited from the valence band to the conduction band. In the N layer, since roughly 100% of the donor is ionized at room temperature, carrier electrons having density of $N_D$ exist in the conduction band. A concentration difference is yielded across the $\mu$-Si$_N$ cluster layer and the N layer, and thus the carrier electrons of the N layer are migrating to the conduction band of the $\mu$-Si$_N$ cluster layer. As the carrier density of the N layer is sufficiently higher than the carrier density of the $\mu$-Si$_N$ cluster layer ($n_i << N_D$), carrier electrons having average density of $N_D x_N / (x_S + x_N)$ migrate from the depletion layer of the N layer to the $\mu$-Si$_N$ cluster layer. In the depletion layer of the N layer, the donor positive electric charge on the average density of $N_D x_N / (x_S + x_N)$ having the volume corresponding to the volume loss of the negative electric charge loss, appears. Meanwhile, the extremely thin P layer is, in its entirety, in the space charge layer of the depletion layer and the acceptor layer having high concentration is ionized roughly 100% at room temperature. Carrier holes of the density NA exist in the valence band. Due to a concentration difference between the $\mu$-Si$_N$ cluster layer and the P layer, the carrier holes in the P layer flow to the valence band of $\mu$-Si$_N$ cluster layer. An acceptor negative electric charge on the average density of $N_A x_P /(x_S + x_N)$ having the volume corresponding to the volume loss of the positive electric charge is similarly generated in the depletion layer of the P layer. Under a conditional equation (7) in which the both volume losses are equal, the carriers flown respectively from the N layer and the P layer are balanced in the $\mu$-Si$_N$ cluster layer, and the space charge density reaches near 0 on average.

$$N_D \frac{x_N}{x_S + x_N} = N_A \frac{x_P}{x_S + x_P} \approx N_A \frac{x_P}{x_S}, \qquad (x_P << x_S) \qquad (7)$$

Locally, although many carrier holes (positive electric charge) are unevenly distributed in the P layer side having a negative electric charge and many carrier electrons (negative electric charge) are unevenly distributed in the N layer side, the space charge density is lowered to 0 (N = 0) in an interface of the both electric charge distributions. Fermi level in the interface is positioned just at the center of a band gap in the interface ($E_F = \Delta Es / 2$). In the P-Si$_N$-N junction in a thermal equilibrium state, there is no carrier transfer, and therefore each Fermi level in the P layer, the $\mu$-Si$_N$ cluster layer, and the N layer coincide with one another. However, since the actual $\mu$-Si$_N$ cluster layer contains impurities, carries having a density far exceeding $n_i$ are already exist in the $\mu$-Si$_N$ cluster layer before carrier transfer from the N layer and the P layer. When the impurities are the donor, carrier electrons migrate to the P layer, and positive electric charges exist in advance at room temperature in the $\mu$-Si$_N$ cluster layer. As a result of shift of the Fermi level in the direction of a conduction band edge, a valence band edge $E_{VS}$ of the $\mu$-Si$_N$ cluster layer having a wide band gap falls below a valence band edge $E_{VN}$ of the N layer, which limits migration of the carrier holes. When the impurities are the acceptor, carrier holes migrate to the N layer, and the $\mu$-Si$_N$ cluster layer has a negative electric charge at room temperature. As a result of shift of the Fermi level in the direction of a valence band edge, the conduction band edge $E_{CQ}$ of the $\mu$-Si$_N$ cluster layer is positioned at the upper location than that of a conduction band edge $E_{CP}$ of the P layer, which limits migration of the carrier electrons.

As a result of the above consideration, it is desirable that the $\mu$-Si$_N$ cluster layer in the P-Si$_N$-N junction should be fabricated using high purity silicon materials having a property close to the intrinsic semiconductor, namely silicon materials which can be used for the donor or the acceptor, manufactured by a process which is able to control impurity concentration, at least 1 ppb or less, preferably 0.1 ppb or less. It is concluded that high purified $\mu$-Si$_N$ cluster layer should be formed.

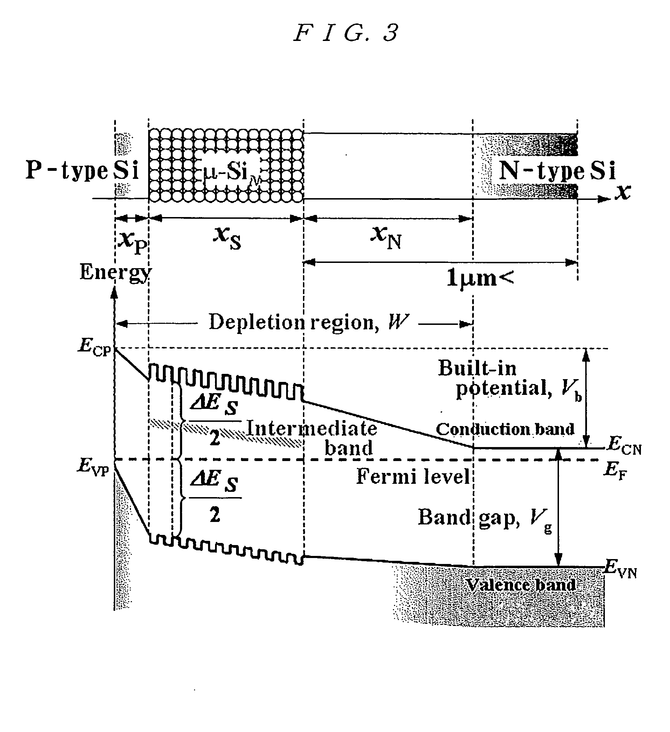

Consideration is made here to a band structure in the P-Si$_N$-N junction in which the $\mu$-Si$_N$ cluster layers formed of the high purity silicon close to the intrinsic semiconductor are stacked by 100 to 300 layers. The band structure in the P-Si$_N$-N junction of the present invention is shown in FIG. 3. A structure of the P-Si$_N$-N junction and the thickness of each layer are shown in an upper section of FIG. 3. Corresponding to said structure, an energy structure is shown in a lower section of FIG. 3. In the $\mu$-Si$_N$ cluster layer existing in the depletion layer of the P-N junction, a carrier electron and a carrier hole flow from each of the N layer and the P layer respectively. Under a condition where the equation (7) is established, an average space charge is 0 in the $\mu$-Si$_N$ cluster layer, and the Fermi level is positioned just at the center of the band gap. There is no carrier transfer in a thermal equilibrium state and each Fermi level in the P layer in the P-Si$_N$-N junction, the $\mu$-Si$_N$ cluster layer, and the N layer coincide with one another. The built-in potential V$_b$ is defined by a potential difference between negative potential at the P layer side and positive potential at the N layer side across the inserted layer of the electrically neutral $\mu$-Si$_N$ cluster layer. As the Fermi level of the $\mu$-Si$_N$ cluster layer is positioned just at the center of the band gap, the built-in potential V$_b$ can be set high, which forms the P-Si$_N$-N junction having large open circuit voltage.

When the $\mu$-Si$_N$ cluster layers formed by stacking the periodically arranged $\mu$-Si$_N$ cluster is defined with rectangular period potential (Kronig-Penny potential), permissible energy level of electrons is discrete following the equations (1) and (2) representing an energy dispersion relation of electrons E (k, a$_P$, b$_P$), and an intermediate energy level is formed. An absorption edge forming a base by the energy level of the valence band and the intermediate energy level has a longer wavelength compared with an absorption edge of the silicon(wavelength $\lambda$m = 1.1$\mu$m) defined by band gap V$_g$, and raises a quantum efficiency in a long wavelength range.

First Embodiment

A silicon cluster solar battery device according to the present invention will be explained. The first embodiment describes a design guideline necessary for fabricating a practical solar battery utilizing a $\mu$-Si$_N$ silicon cluster refined to 2 nm to 2.5 nm in particle diameter, by the use of the silicon cluster technology introduced in the present invention. The present first embodiment solves the above-identified technical problems 2 and 3.

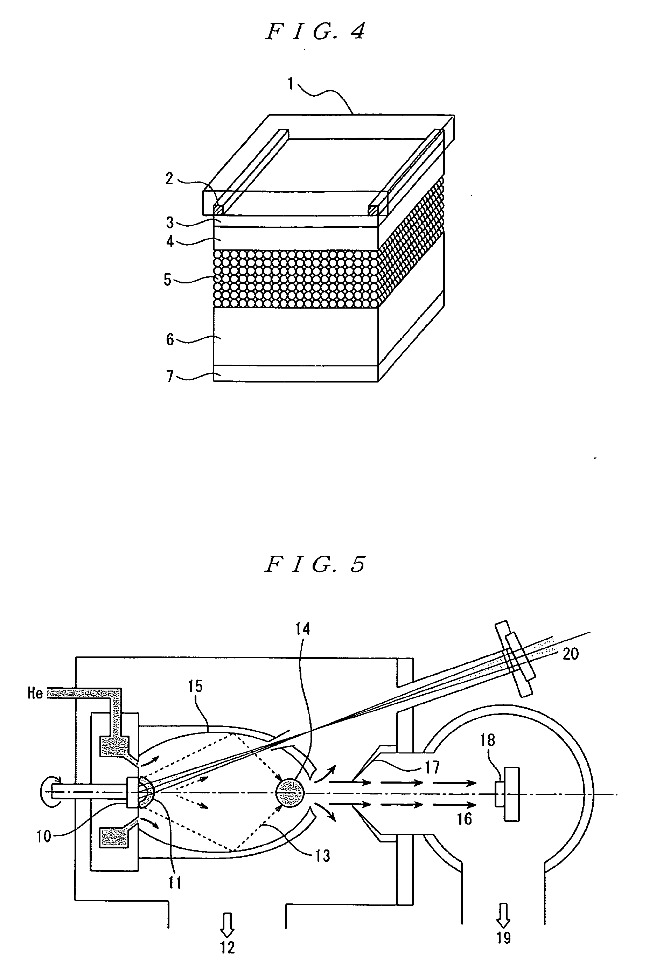

The first embodiment is the basic structure of the present invention which is related to all silicon p-Si$_N$-N junction where a refined silicon cluster is inserted between the P-N junction on the basis of the simplest P-N junction. This is a basic solar battery structure of the present invention. FIG. 4 is a view showing a device structure of the silicon cluster solar battery. The first embodiment will be described referring to FIG. 4. As shown in FIG. 4, the device according to the first embodiment comprises a glass substrate 1; a lead-out electrode 2; a transparent electrode 3; a P-type fine crystal silicon 4; a quantum dot 5 of the silicon cluster ($\mu$-Si$_N$); a N-type amorphous silicon or N-type fine crystal silicon 6; and an electrode 7. The device structure according to the first embodiment is manufactured by firstly embedding the Ag lead-out electrode 2 in the glass substrate 1 so as to expose its electrode surface, and by secondly depositing the transparent electrode 3 thereon, such as ITO etc. Next step is stacking after the P-type fine crystal silicon (p-Si)4, the quantum dot 5 of the silicon cluster ($\mu$-Si$_N$) having refined particle diameter of 2 nm to 2.5 nm, the N-type amorphous silicon (a-Si) or N-type fine crystal silicon (p-Si) 6, then depositing an Al back electrode 7 finally. Note that the (a-Si) is used as an abbreviation of the amorphous silicon and the (p-Si) is used as an abbreviation of the fine crystal silicon.

The present P-Si$_N$-N junction-based device structure is characterized in that a refined silicon cluster ($\mu$-Si$_N$) thin film having even particle diameter of 2 nm to 2.5 nm is used in the quantum dot layer. The $\mu$-Si$_N$ thin film is formed by depositing a $\mu$-Si$_N$ cluster having the same size on the substrate using the cluster beam deposition (see Patent Document 1). The $\mu$-Si$_N$ cluster is formed by the laser evaporation in a spatiotemporal confinement type cluster source, and cluster growth is controlled in a short time by confinement of a shock wave happened in gas in the cluster source. In this way, micro size silicon cluster having small size dispersion (below 5%) and has a particle diameter of 2.5 nm or less is obtained. The $\mu$-Si$_N$ cluster produced by the shock wave in a high compression state in the cluster source is led out in a vacuum as a beam and then is incident on the substrate after flying in the vacuum with energy higher than 1eV per Si atom. The higher the deposition density on the substrate, the shorter the adjacent distance of the $\mu$-Si$_N$ cluster. When interaction between the clusters extends to a large and wide range, the $\mu$-Si$_N$ cluster repeats rearmament and high symmetric array order is formed. According to observation by means of the Transmission Electron Microscope (TEM) using the High-Angle Annular Dark Field (HAADF), when the $\mu$-Si$_N$ cluster is coated over the entire surface of one layer on the substrate (coverage factor = 1), the density of the $\mu$-Si$_N$ cluster is $1 \times 10^{13}$/cm$^2$. When the deposition density of the $\mu$-Si$_N$ cluster is $2 \times 10^{12}$/cm$^2$ (coverage factor = 0.2), two Si$_N$ clusters adjacent to each other at a rate of 78.3% form a pair shortening neighboring distance of $\mu$-Si$_N$ clusters. Meanwhile, when the deposition density is further increased and reaches $6.5 \times 10^{12}$/cm$^2$ (coverage factor = 0.65), plural neighboring $\mu$-Si$_N$ clusters nearby are gathered to form a close-packed structure in six equal squares form arranged at a position of the apex of equilateral triangle. As a result, a local array order is formed. When the substrate is fully coated (coverage factor=1), the $\mu$-Si$_N$ clusterof 2.3 nm in average particle diameter is close to an inter-nuclear distance of 3.1 nm, and an arrangement order in the form of tetragonal structure with high symmetry over a large area of 100 nm $\times$ 100 nm is formed.

The number of atoms comprising the $\mu$-Si$_N$ cluster of 2.5 nm in particle diameter is about 400. A cage structure peculiar to the $\mu$-Si$_N$ cluster, where one cluster is formed by piling up micro cages composed of Si atoms of 6 to 11 emerges on a surface layer. This cage structure has a distance of closest approach between silicon atoms of the cage structure of 2.5 Å compared with a lattice constant of 2.36 Å of crystalline silicon, and the cage structure contains a n electron. The cage structure forms sp$^2$ hybrid orbital that can be seen in graphite and has the characteristics of an electron structure excellent in conductivity. On the other hand, in the inside of the $\mu$-Si$_N$ cluster, a $\sigma$ electron is dominant and therefore sp$^3$ hybrid orbital is formed. An electron confined in a nanospace forms quantum level according to the quantum mechanics. An energy gap width of the $\mu$-Si$_N$ cluster increases according to a decrease in size. The energy gap width of the $\mu$-Si$_N$ cluster of 2 nm to 2.5 nm in particle diameter exceeds 2eV compared with the energy gap width of 1.17eV of silicon single crystal having a diamond structure

The $\mu$-Si$_N$ cluster thin film used in the P-Si$_N$-N junction quantum dot solar battery according to the first embodiment of the present invention shows a superior characteristic almost satisfying the conditions necessary for the silicon cluster dot layer to function as a solar battery, which are problems to be solved by the present invention. The P-Si$_N$-N junction-based device structure made of the $\mu$-Si$_N$ cluster thin film forms the basis of the silicon cluster solar battery of the present invention.

Below, a manufacturing method of the silicon cluster solar battery will be described in detail. The method includes forming an electrode on the transparent substrate (step 1);forming the ITO transparent electrode (step 2); forming the P-type fine crystal silicon (step 3); forming the silicon cluster (step 4); depositing the N-type fine crystal silicon (step 5);and forming the Al earthed electrode at reverse face (step 6).

As a glass substrate, an ultra-precision machined high-grade glass (BDA/ABC, Nippon Electric Glass Co., Ltd) is used. In the glass substrate dust emission from an end face is prevented and a surface is finished to have high cleanness by ultra-precision polishing. The glass substrate uses an ultra thin plate manufactured using the over flow method (thickness 0.5 mm), which has mechanical properties, such as high transparency, thermally high dimensional stability, high hardness, and flexibility, and has high chemical resistance. Mechanical, chemical, and optical properties of the glass substrate are shown in TABLE 1.

| Density | $\times$10^ 3Kg/m^ 3 | 2.46 |
|---|---|---|
| Young's modulus | GPa | 73 |
| Poisson's ratio | | 0.2 |
| Vicker's hardness | | 600 |
| Chemical resistance | 10%HCl(80°C-60min) | no surface alternation |
| | 63DHF(20°C-60min) | no surface alternation |
| Content percentage of alkali | wt% | below 0.1% |
| Content percentage of As and Sb | wt% | not contained |
| Moisture vapor transmission ratio | g/m^ 2 day | less than 10$^{-5}$ |
| Optical transmittance | $\lambda$ = 550nm | 92% |
| Refractive index | $\lambda$ = 587.6nm | 1.52 |

The Ag lead-out electrode is embedded in a surface of the glass plate so as to expose its electrode surface, and is set to a vacuum chamber of a RF sputtering vapor deposition system (step 1). In the RF sputtering vapor deposition system, forming the ITO transparent electrode (step 2); forming the P-type fine crystal silicon (step 3); and depositing the N-type fine crystal silicon (step 5) are performed.

The RF sputtering vapor deposition system is a device for depositing a high purity semiconductor thin film under clean environment of ultra-high vacuum, for RF sputtering a target sample of a required base material, and for depositing, under clean environment, on the substrate having a clear surface, where the substrate temperature is controlled. Two systems have been fabricated respectively for film deposition of the ITO transparent electrode and for film deposition of the P-type and the N-type poly crystal silicon. In the both systems, the target base material is horizontally mounted upwardly on the RF electrode plate, and A$_r$ is introduced under pressure of 1Pa to 10Pa. The deposited substrate is horizontally mounted downwardly facing to the target base sample, and a RF of 13.56MHz is applied to the RF electrode plate by the maximum power of 300 W. During the film deposition of the ITO transparent electrode, $O_2$ is introduced in concert with $A_r$ under pressure of $10^{-2}$ Pa to $10^{-3}$ Pa to control a characteristic of electrode materials. During the film deposition of the polycrystalline silicon, $A_r + H_2$ are introduced. In the both systems, when defining collision energy that ion generated by the RF spattering is running into the substrate, RF output voltage is controlled. On the other hand, when defining a lamination rate, RF output voltage is controlled for film deposition. On a deposition surface of the substrate, a clean surface is formed by RF sputtering and by heating annealing before deposition. Substrate temperature during deposition is controlled to temperature around 200 °C in case of polycrystalline silicon, and to constant temperature up to 500 °C at maximum in case of ITO transparent electrode.

A vacuum tank ensures film deposition space having a large inside diameter of 300 mm or more to realize thin film deposition under clean environment, and achieves ultra-high vacuum specifications below $5 \times 10^{-8}$ Pa, by mounting a water-cooled turbo pump having ultimate vacuum of $1 \times 10^{-5}$ Pa and a pumping speed of 800 L/s, and a dry pump. In the manufacture of the solar battery, the device is manufactured consistently under an ultra-high vacuum, to prevent impurities, including water etc., from being mingled on a bonded interface of the device structure (FIG. 4). In the RF sputtering vapor deposition system and the cluster beam deposition system, there is provided a load lock function to enable mutual conveyance of a deposited substrate in a vacuum between the both systems.

The step (step 4) of fabricating the silicon cluster will be explained below. The $\mu$-$Si_N$ cluster layer is formed by stacking the $\mu$-$Si_N$ clusters in the cluster beam deposition system. FIG. 5 shows a silicon cluster beam deposition system. The cluster beam deposition system is a system, equipped with a laser evaporation spatiotemporal confined cluster source, for forming a $\mu$-$Si_N$ cluster thin film by using a $\mu$-$Si_N$ cluster beam generated by controlling its size (see Patent Document 2). In FIG. 5, reference numerals 12 and 19 denote evacuation. An Si target sample 10 is set to an elliptical focus of a cluster generation cell (elliptical cell 15) having an elliptical inner wall, and a Nd-YAG laser beam 20, having a wavelength of 532 nm, energy of 800 mJ, and pulse widths of 11 ns to 13 ns, is radiated to the target sample, while introducing helium thereinto at a given constant pressure of 1 Pa to 10 Pa. A shock wave (reflected shock wave 13) propagating through helium is reflected on a cell inner wall by a Si plume (evaporation of the sample) generated at the focus of the elliptical cell to confine Si steam in the helium for 100 $\mu$s to 300 $\mu$s, and a $\mu$-$Si_N$ cluster is formed at a local boundary stream where the helium and the Si steam are mixed. A cluster formation area is indicated schematically by part 14 of a diagonal lined circle. When the cluster growth occurs, only in a certain local area where the helium and the Si steam are in a thermal equilibrium state, a micro $\mu$-$Si_N$ clusters with even size of 1 nm to 2.5 nm in particle diameter is produced. The produced $\mu$-$Si_N$ cluster contains a few electric charge components and over 90% of it is neutral. The $\mu$-$Si_N$ cluster is ejected with a helium flow from a cell outlet opened facing to the target sample 10, and led out as a $\mu$-$Si_N$ cluster beam 16 into a vacuum through a skimmer 17. The neutral $\mu$-$Si_N$ cluster beam travels in the vacuum with high kinetic energy of 1eV or more per one Si atom and is finally deposited on the substrate 18 set in the vacuum tank adjacent to the cluster source. High kinetic energy of 1eV or more is converted into internal energy of the $\mu$-$Si_N$ cluster when the cluster beam is collided against the substrate 18, which promotes rearrangement of the $\mu$-$Si_N$ cluster on the substrate 18, and enables formation of the periodic arrangement in the $\mu$-$Si_N$ cluster layer. As shown in FIG. 5, the silicon cluster layers according to the present invention are produced by deposition in vacuum of a silicon cluster beam incident on a substrate surface at an energy so high enough to arrange the silicon clusters in order on the substrate surface but not too high to collide with the substrate surface without dissociation of the silicon clusters, wherein the silicon cluster beam is generated by evaporating a silicon target material set in a cell filled with a laminar elium flow, and by generating silicon clusters in a mixed gas domain of silicon vapor and the inert gas formed at the interface of the evaporated silicon vapor in contacting with the laminar helium flow, and by extracting the generated silicon clusters along with the laminar helium flow out of the cell into vacuum, and introducing the generated silicon clusters onto the substrate surface, wherein the mixed gas domain is confined and compressed in a localized space by collision with a shock wave induced by laser ablation in the laminar helium flow, and the velocity of the transportation of silicon clusters onto the substrate surface along with the laminar helium flow is accelerated by the mixed gas domain up to at least 4 times or much higher than the velocity of free-expansion of helium into vacuum, but maximum lower than the velocity in terms of the kinetic energy of the constituent silicon atoms equivalent in amount to the binding energy of the silicon clusters.

High purity silicon single crystal having resistivity $\geqq$ 1000 $\dot{\Omega}c$ is used for a target sample to produce the $\mu$-$Si_N$ cluster. Usually, in place of FZ method (floating zone melting method), the high purity silicon single crystal is produced by the FZ method using single crystal silicon produced by CZ method (Czochralski method) as raw materials (CZ method + FZ method). Comparing with the general FZ method that high purity silicon single crystal is fabricated using columnar silicon as raw materials, the cost is reduced approximately to 1/5. The silicon single crystal is fabricated by the CZ method + FZ method is a P-type silicon which shows a property of resistivity $\geqq$1000 $\dot{\Omega}$cm and lifetime over 200 $\mu$s. The fabricated high purity silicon single crystal is formed and used by fitting to a target sample holder of the spatiotemporal confinement cluster source.

A $\mu$-$Si_N$ cluster thin layer is formed (step 4); and the Al electrode is finally deposited on the back electrode (step 6) after N-type fine crystal silicon (p-Si) is deposited (step 5).

It is important to form a high purity $\mu$-Si$_N$ cluster layer by producing a $\mu$-Si$_N$ cluster in the P-Si$_N$-N junction using silicon materials produced by a production method in which impurity concentration is controllable at least to 1 ppb or less, or ideally to 0.1 ppb or less, which are high purity silicon materials showing a property close to an intrinsic semiconductor i.e., can be used as a donor or an acceptor. It can be concluded that the $\mu$-Si$_N$ cluster layer in the P-Si$_N$-N junction acts most effectively when the number of stacks of the $\mu$-Si$_N$ cluster layers is set to about same level as that of a depletion layer region in the P-Si$_N$-N junction and the thickness is about twice as that of the N layer depletion layer at most i.e., when the $\mu$-Si$_N$ cluster layers having a particle diameter of 2 nm to 2.5 nm, to 3 nm are stacked by100 to 300 layers with stacking interval of 3nm.

An important factor to determine efficiency of the solar battery is quantum-conversion efficiency. To surpass the theoretical limiting efficiency 31 % of the conversion efficiency of solar battery that utilizes the single crystal silicon as a material, the $\mu$-Si$_N$ cluster layer is required to have a high conversion ratio exceeding the quantum-conversion efficiency of the single crystal silicon. As stated above, the number of stacks that the $\mu$-Si$_N$ cluster layer most effectively operates is 100 layers to 300 layers, in other words a thin film solar battery. That is, to increase efficiency of the silicon cluster solar battery, as is pointed out in the above technical problem 4, the $\mu$-Si$_N$ cluster layer is required to exhibit high absorption coefficient to sunlight spectrum.

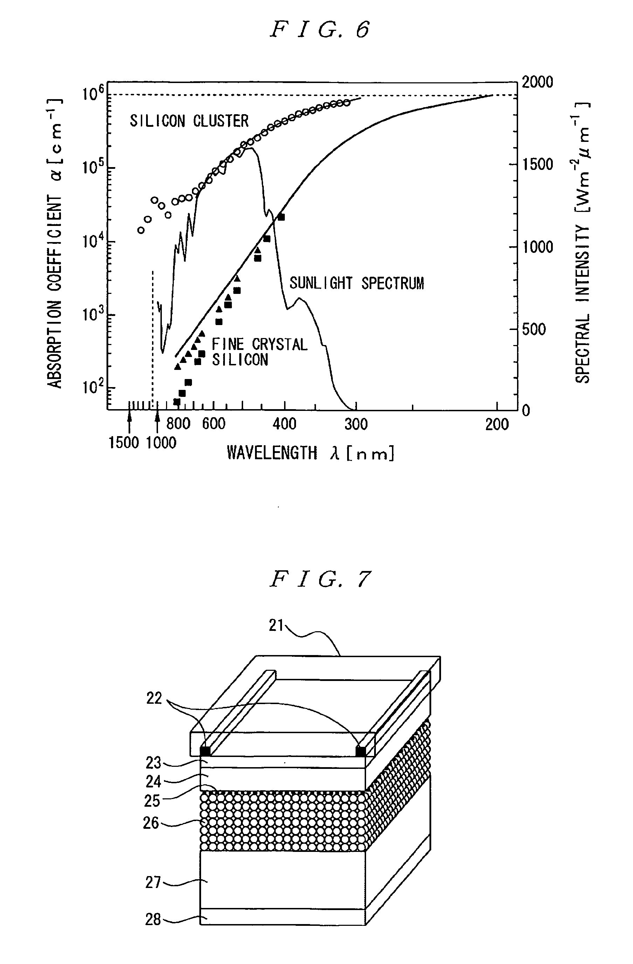

It is known that light absorptivity to sunlight spectrum of the silicon cluster thin film having a particle diameter of 2 nm to 3 nm is 2 digits higher than that of the fine crystal silicon. According to the light absorption data by University Claude Bernard Lyon, 1998, light absorption coefficient $\alpha_0$ of the silicon cluster film having particle of 2 nm to 3 nm shows $\alpha_0 = 2 \times 10^4$ cm$^{-1}$ at around a wave length region of 1000 nm, which is 2 digits larger than that of the fine crystal silicon, $\alpha_0 = 1 \times 10^2$ cm$^{-1}$. The light absorption data by Universite Claude Bernard Lyon (reduced value based on Tauc's plot) and the absorption coefficient of the fine crystal silicon are shown in FIG. 6. Intensity of sunlight spectrum on the ground is also shown in FIG. 6. According to FIG. 6, the absorption coefficient of the silicon cluster is 2 digits larger than the fine crystal silicon. Namely, whereas the fine crystal silicon needs to have thickness of 230 $\mu$m to absorb 90% or more of light having a wavelength of 1000 nm, silicon cluster thin film having a particle diameter of 2 nm to 3 nm needs to have thickness of 1.2$\mu$m. Around wavelength of 600 nm, the light absorption coefficient of the silicon cluster thin film is $\alpha_0 = 1 \times 10^5$ cm$^{-1}$ and the thickness necessary to absorb 90% of the light having 230 nm. In case of the silicon cluster thin film having a particle diameter of 2 nm to 3 nm, the number of stacking of the silicon cluster has thickness corresponds to 70 layers. Based on a result of FIG. 6, thickness of the silicon cluster thin film necessary to attain sufficient absorption to sunlight spectrum is about 1 $\mu$m. This shows there is high possibility of thin film technology of the solar battery having the silicon cluster thin film in a quantum dot layer. Note that, while the silicon cluster thin film in the data by the University Claude Bernard Lyon has an average particle diameter of 2 nm to 3 nm, an intermediate level is not formed. In other words, a broken line indicated in a wavelength of 1100 nm shown in FIG. 6 is an absorption end of the silicon crystal i.e., a wavelength corresponds to a band gap of $V_b = 1.17$ eV. Although an absorption end of the absorption coefficient data by the University Claude University Bernard Lyon is Vg = 1.56 eV by a quantum size effect, which shows widening of the band gap, since the absorption coefficient abruptly drops nearby the absorption end, formation of a new intermediate energy level is not taken place in a forbidden gap that is a primary objective of the quantum dot solar battery. The present invention is for realizing the intermediate energy level by forming a cluster film having periodicity for the cluster array. Namely, the silicon cluster produced in the spatiotemporal confinement cluster source is collided against a surface of the substrate with kinetic energy about one digit higher, compared with a cluster produced by the conventional laser evaporation. Different from atoms or molecules, the cluster composed of large number of atoms has a large internal degree of freedom, and thus the greater part of kinetic energy remains as internal energy (lattice vibration of the cluster) without migrating to the substrate concurrently with the collision. As a distance of the inter-cluster on the substrate shortens with the progress of evaporation, it tends to take a more stable arrangement structure (structure having high symmetry) between adjacent multiple clusters. When one cluster collides against the substrate with high energy, internal energy of the collided cluster is propagated to adjacent clusters, which progresses rearrayment thereof. A velocity at which the cluster begins rearrayment is determined by frequency of collisions between adjacent clusters on the substrate (when the cluster makes a lattice shape, its lattice vibration frequency) and ratio of internal temperature of the cluster to energy necessary for rearrayment. Meanwhile, a velocity that the cluster begins to arrange disorderly is determined by a frequency that the cluster collides disorderly against the substrate. On the substrate, a process of ordering by rearrayment of the cluster competing with a process of disordering by collision against the substrate is generated. When a rearrayment speed of the cluster is higher than that of disorder rearrayment, formation of orientation order (periodic structure) of the cluster progresses. Thus, in the silicon cluster technology according to the present embodiment where incident energy on a surface of the substrate of the cluster is set high, possibility that the silicon cluster arrays periodically becomes higher.

Second Embodiment

The second embodiment according to the present invention further provides a passivation film in addition to the elements in the first embodiment. The second embodiment will be explained referring to FIG. 7. FIG. 7 is a view showing a device structure according to the second embodiment. As shown in FIG. 4, the device according to the second embodiment includes a glass substrate 21; a lead-out electrode 22; a transparent electrode 23; a P-type fine crystal silicon 24; a passivation film 25; a quantum dot 26 of the silicon cluster ($\mu$-Si$_N$); N-type amorphous silicon or N-type fine crystal silicon 27, and an electrode 28. Typically, as a device structure according to the second embodiment, the Ag lead-out electrode 22 is firstly embedded in the glass substrate 21 so as to expose thereon its surface of the electrode, and the transparent electrode 23, such as an ITO is deposited thereon. Then, P-type fine crystal silicon (p-Si, thickness 10 nm) 24, the passivation film (graphite single layer) 25, a quantum dot (100 layers to 300 layers) 26 of the silicon cluster ($\mu$-Si$_N$) refined to 1 nm to 3 nm in particle diameter, N-type amorphous silicon (a-Si) or N-type fine crystal silicon (p-Si) 27 (thickness of 1 $\mu$m) are stacked. Thereafter, an Al back electrode (earth electrode) 28 is finally deposited.

As is shown in the aforesaid technical problem 5, one important factor to determine efficiency of the silicon cluster solar battery is a carrier lifetime. In the quantum dot solar battery, it is feared that the carrier lifetime shortens due to capture of carriers on an interface between quantum dots having a large surface area. Therefore, interface control to extend the carrier lifetime of the quantum dot layer is necessary. In the P-Si$_N$-N junction utilizing the $\mu$-Si$_N$ cluster, it is pointed out in the above that the cage structure peculiar to the the $\mu$-Si$_N$ cluster locally exits on the surface of the cluster. This cage structure has a n electron and shows an electron structure state excellent in conductivity just as the graphite forming sp$^2$ hybrid orbital. It was stated that since no unpaired electrons exist on the surface of the silicon cluster, and so the silicon cluster, which makes carrier conductivity excellent, a carrier lifetime longer by several digits can be expected, compared with a carrier lifetime on the surface of the silicon single crystal.

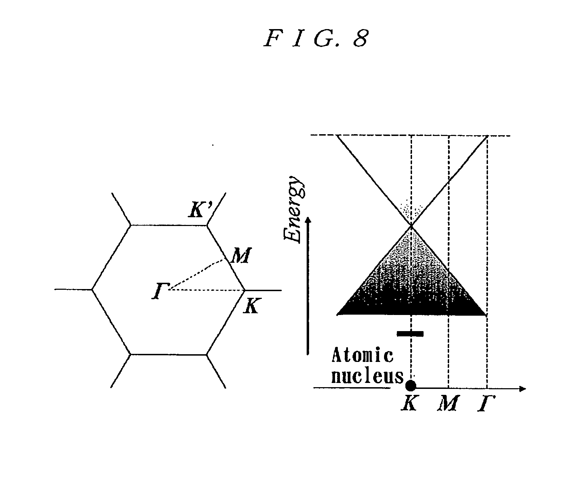

For interface control of the $\mu$-Si$_N$ cluster layer, the P layer, and the N layer, utilization of a graphene layer where 1 to 5 layers of carbon atom layers having superiority as a passivation thin film are stacked can be considered. The graphene is a thin film which is artificially formed by isolating atomic layers made of 1 layer to several layers, from graphite that is known by having a crystal structure where atomic layers where a carbon atom is arranged at an apex of a regular hexagon are stacked. While the thin film has very thin thickness ranging from 1 layer to several layers of the atomic layers, it has a shape extending over 100 $\mu$m in size in case of large one. Electrons in the graphene show behavior as a particle following the theory of relativity, and achieve high mobility not dependent on temperature. Graphene quantum dot (GQD) forming a quantum confinement state against electrons behaving following the theory of relativity is expected as nano-electronics materials which have the both of high carrier mobility and quantum state controllability. In the graphene, electrons form a continuous energy band free from a band gap in the vicinity of a carbon atomic nucleus and migrate freely in solid. As the electron drives away from the atomic nucleus, an energy band of the electron is gradually discrete. But, because an energy dispersion width and a distance from the atomic nucleus are linear, an electron travels at a speed described in the relativistic quantum mechanics i.e., close to light speed c* in a solid (C* = C$_0$/300, where C$_0$ is light speed in a vacuum), therefore mass of the electrons become close to 0 (m* = 0, m* is effective mass). In the 1.9 GeV synchrotron radiation ring (Advanced light Source) facility at Lawrence Berkeley National Laboratory in 2007, an electron state described in the relativistic quantum mechanics of the graphene is demonstrated. Herein, interaction between the graphene and the $\mu$-Si$_N$ cluster will be considered. The consideration shows that overlap of a wave function of electrons between a n electron in the surface of the graphite and a n electron in a surface layer of the $\mu$-Si$_N$ cluster is observed, and it becomes apparent, that electrons in the graphene migrate to the $\mu$-Si$_N$ cluster as a result of computer simulation. Based on the computer simulation, when the $\mu$-Si$_N$ cluster is absorbed on a surface of the graphene, at a local area of the graphene contacting the cluster, electrons in the graphene migrate to the inside of the $\mu$-Si$_N$ cluster where a local quantum confinement state is generated. As for an absorption position on the surface of the graphene of the $\mu$-Si$_N$ cluster, it is found that the absorption of the Si atom on the carbon nucleus i.e., at a position of the K, K' is stable. An energy dispersion relation of the graphene is shown in FIG. 8. In FIG. 8 a reciprocal lattice of the graphene crystal structure is shown on the left, a relation (dispersion relation) between a wave number of electrons and energy corresponding to the reciprocal lattice is shown on the right. By defining the absorption position of the $\mu$-Si$_N$ cluster on the surface of the graphene, it can be expected that the $\mu$-Si$_N$ cluster on the surface of the graphene arrangements ays with high symmetry and periodicity with high precision at an atomic level.

In the second embodiment, as a promising passivation material on an interface of the junction of the silicon cluster solar battery, an example where the P-Si$_N$-N junction utilizing the graphene is included in a device design is shown. A production method of the silicon cluster solar battery according to the second embodiment will be explained below. A step of the second embodiment is basically as same as that of the first embodiment except that a deposition step of a passivation film (graphene) is provided between the steps (step 3) of depositing the P-type fine crystal silicon of the process according to the first embodiment and a process (step 4) of forming the silicon cluster.

The passivation film (graphene) is formed by producing, dispersion solution in which graphene refined from graphite by chemexfoliation is dispersed in methanol or in anhydrous propanol, and by dropping the graphene dispersion solution on a surface of the substrate on which deposition of the P-type fine crystal silicon is finished (step 3) in an Ar atmosphere. It is necessary that the density of the graphene dispersion solution is adjusted so as to form a monolayer graphene thin film after evaporation of a solvent of the dispersion solution.

After stacking of a graphene monolayer film 25 on stacked P-type fine crystal silicon 24, the $\mu$-Si$_N$ cluster 26 is deposited. The $\mu$-Si$_N$ cluster flying with energy of 1 eV or more per Si atom migrates on the surface of the graphene, and is adhered to a position at which Si atom of the cluster is absorbed to K,K' at the surface of the graphene. After the $\mu$-Si$_N$ cluster is periodically arranged with high precision and a $\mu$-Si$_N$ cluster monolayer is formed on the surface of the graphene 25, the $\mu$-Si$_N$ cluster layers following second layer form similarly a periodic arrangement with high prevision along the periodic arrangement of the $\mu$-Si$_N$ cluster monolayer. In the $\mu$-Si$_N$ cluster layer composed of 300 or less layers stacked, a stable intermediate energy level is formed due to the periodically arranged $\mu$-Si$_N$ cluster with high precision, thereby fabrication of a high efficiency silicon cluster solar battery is possible. Further, carriers generated in the $\mu$-Si$_N$ cluster layer 26 are transferred to the valence band of the P-type layer 24, with a longer lifetime without extinction. through the monolayer graphene 25 inserted between interfaces of the P layer 24 In other words, after the carriers generated inside of the $\mu$-Si$_N$ cluster layer reach the $\mu$-Si$_N$ cluster layer in a surface layer a wave function of the carrier particles overlaps with the monolayer graphene 25 inserted in the interface of the P layer 24, and they smoothly migrate to the graphene. On the surface of the graphene, the carriers smoothly migrate to the valence band of the P-type layer through extremely very high conductive state described in the relativistic quantum mechanics. Because the carriers generated in the $\mu$-Si$_N$ cluster layer has longer lifetime, fabrication of a silicon cluster solar battery having high conversion efficiency is possible.

While the examples given in the aforesaid embodiments are described only with the intention of easily understanding the present invention, it is clear and obvious that the present invention is not limited to the foregoing embodiments.

Reference Signs List

1,21: glass substrate
2,22: lead-out electrode (Ag)
3,23: transparent electrode (ITO)
4,24: P-type polycrystal silicon (p-Si)
5,26: silicon cluster layer ($\mu$-Si$_N$ quantum dot)
6,27: N-type amorphous layer (a-Si) or N-type poly
crystal layer (p-Si)
7,18: electrode (AL)
10: Si target sample
11: evaporation of sample (proom)
12,19: evacuation
13: reflected shock wave
14: cluster formation area
15: elliptical cell
16: Si cluster beam
17: skimmer
18: substrate sample
20: laser beam
25: passivation film
$\mu$-Si$_N$: refined silicon cluster
$x_p$: thickness of P layer
$N_A$: acceptor density
$E_{CP}$: P layer conduction band edge
$E_{VP}$: P layer valence band gap
$X_N$: thickness of depletion layer of N layer
$N_D$: donor density
$E_{CN}$: N layer conduction band edge
$E_{VN}$: N layer valence band edge
W: thickness of depletion layer (W=$x_p$+ $x_N$)
$x_s$: stacking thickness of $\mu$-Si$_N$ cluster layer
$\Delta E_s$: band gap energy of $\mu$-Si$_N$ cluster layer
$\varepsilon_m$: maximum electric field to be applied to depletion layer

**Claims**

1. A solar battery comprising a quantum dot layers possessing a multiple energy level structure consisting of energy levels of a valence band and energy levels of a conduction band, and intermediate energy levels formed between both the bands,
wherein the quantum dot layers are composed of silicon clusters of 2.5 nm or less in average diameter forming up periodically in order at an inter-distance of 1 nm or less.

2. The solar battery according to claim 1, wherein the quantum dot layers are composed of the silicon cluster layers stacked up to 300 layers or less and a thickness of the quantum dot layers is 1 $\mu$m or less.

3. The solar battery according to claim 1, wherein the quantum dot layers are laid between a P-type silicon layer and a N-type silicon layer.

4. The solar battery according to claim 1, wherein a graphene layer is laid on an interface of the quantum dot layers.

5. The solar battery according to claim 4, wherein the graphene layer is laid between the quantum dot layers and the P-type silicon layer.

6. A production method of a solar battery, comprising quantum dot layers possessing a multiple energy level structure consisting of energy levels of a valence band, energy levels of a conduction band, and intermediate energy levels formed between both the bands, wherein the quantum dot layers are composed of silicon clusters forming up periodically in order.

7. The production method of a solar battery according to claim 6,
wherein the quantum dot layers are produced by deposition in vacuum of a silicon cluster beam incident on a substrate surface at an energy so high enough to arrange the silicon clusters in order on the substrate surface but not too high to collide with the substrate surface without dissociation of the silicon clusters,
wherein the silicon cluster beam is generated by evaporating a silicon target material set in a cell filled with a laminar helium flow,
and by generating silicon clusters in a mixed gas domain of silicon vapor and the inert gas formed at the interface of the evaporated silicon vapor in contacting with the laminar helium flow,
and by extracting the generated silicon clusters along with the laminar helium flow out of the cell into vacuum, and introducing the generated silicon clusters onto the substrate surface,
wherein the mixed gas domain is confined and compressed in a localized space by collision with a shock wave induced by laser ablation in the laminar helium flow,
and the velocity of the transportation of silicon clusters onto the substrate surface along with the laminar helium flow is accelerated by the mixed gas domain up to at least 4 times or much higher than the velocity of free-expansion of helium into vacuum, but maximum lower than the velocity in terms of the kinetic energy of the constituent silicon atoms equivalent in amount to the binding energy of the silicon clusters.

*F I G.  1*

FIG. 2

# F I G. 3

*F I G. 4*

*F I G. 5*

*F I G. 6*

*F I G. 7*

# F I G. 8

## INTERNATIONAL SEARCH REPORT

International application No.

PCT/JP2011/001101

### A. CLASSIFICATION OF SUBJECT MATTER
*H01L31/04*(2006.01)i

According to International Patent Classification (IPC) or to both national classification and IPC

### B. FIELDS SEARCHED

Minimum documentation searched (classification system followed by classification symbols)
H01L31/04

Documentation searched other than minimum documentation to the extent that such documents are included in the fields searched
Jitsuyo Shinan Koho         1922-1996    Jitsuyo Shinan Toroku Koho    1996-2011
Kokai Jitsuyo Shinan Koho   1971-2011    Toroku Jitsuyo Shinan Koho    1994-2011

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y | JP 2004-356163 A  (Toyota Central Research and Development Laboratories, Inc.), 16 December 2004 (16.12.2004), entire text; all drawings (Family: none) | 1-7 |
| Y | JP 2005-322877 A  (Toyota Motor Corp.), 17 November 2005 (17.11.2005), entire text; all drawings (Family: none) | 1-7 |
| Y | "Cluster Seicho Ryoiki no Jikukan Kyokusho Tojikome ni Seiko -Kinosei Cluster Process Gijutsu no Shin Tenkai-", ETL News, vol.600, pages 4 to 9 (2000.01) | 1-7 |

☒ Further documents are listed in the continuation of Box C.      ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 30 May, 2011 (30.05.11) | 07 June, 2011 (07.06.11) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.

PCT/JP2011/001101

C (Continuation).   DOCUMENTS CONSIDERED TO BE RELEVANT

| Category* | Citation of document, with indication, where appropriate, of the relevant passages | Relevant to claim No. |
|---|---|---|
| Y | "Rittai Nano Chitsujo o Keisei suru Silicon Nano Cluster Zairyo -Silicon no Kinosei ni Aratana Hirogari o Motomete-", Expected Materials for the Future, vol.4, no.10, pages 38 to 44 (2004) | 1-7 |
| Y | JP 2007-162059 A  (National Institute of Advanced Industrial Science and Technology), 28 June 2007 (28.06.2007), entire text; all drawings & US 2009/0114848 A1    & WO 2007/069528 A1 | 1-7 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001158956 A

- JP 2007162059 A

**Non-patent literature cited in the description**

- **G. CONIBEER et al.** Silicon quantum dot nanostructures for tandem photovoltaic cells. *Thin Solid Films,* 2008, vol. 516, 6748-6756
- **YASUSI IWATA et al.** Array order formation of silicon nanoblocks and practical application of thin film deposition system. *Laser Processing Academic Journal,* 2003, vol. 10, 57-60

- **YASUSI IWATA et al.** Narrow size-distributed silicon cluster beam generated using a spatiotemporal confined cluster source. *Chem. Phys. Lett.,* 2002, vol. 358, 36-42